Europäisches Patentamt

European Patent Office

Office européen des brevets

(11) Publication number: **0 424 022 A2**

# EUROPEAN PATENT APPLICATION

(21) Application number: 90311112.8

(22) Date of filing: 10.10.90

(51) Int. Cl.5: **C04B 35/00**, C04B 35/64, H01L 39/24

(30) Priority: 14.10.89 KR 1474389

(43) Date of publication of application:
24.04.91 Bulletin 91/17

(84) Designated Contracting States:
DE FR GB NL

(71) Applicant: GOLD STAR CO. LTD
20 Yoido-Dong, Youngdungpo-ku
Seoul(KR)

(72) Inventor: Lee, Pil Hwa
77-1, Oncheon-dong, Dongrae-ku
Pusan(KR)

(74) Representative: Carmichael, David Andrew
Halliday et al
G.F. REDFERN & CO. High Holborn House
52/54 High Holborn
London WC1V 6RL(GB)

(54) Manufacturing process for superconductor of Bi-Pb-Sr-Ca-Cu-O series.

(57) A manufacturing process of a high temperature superconductor is disclosed. First, powders of $Bi_2O_3$, $SrCo_3$, $CaCo_3$, CuO and PbO are measured in the ratios of 1.4 : 0.6 : 2 : 2 : 3.8, and then, they are crushed and mixed together by means of a ball mill. Then the mixture is calcinated two or three times at a temperature of 600 - 800 °C for 24 - 48 hours, and then, sintering is carried out at a temperature of 800 - 900 °C for 48 hours. Then a cold pressing and a hot pressing are carried out, and finally a sintering is carried out for two days. According to the present invention, the manufacturing period is shortened.

F I G. 1
PRIOR ART

```
┌─────────────────────────┐
│ Measuring of raw        │
│   material powders       │
└─────────────────────────┘
            │
            ▼
┌─────────────────────────┐
│        Mixing            │
└─────────────────────────┘
            │
            ▼
┌─────────────────────────┐
│      Calcination         │
└─────────────────────────┘
            │
            ▼
┌─────────────────────────┐
│       Sintering          │
└─────────────────────────┘
            │
            ▼
┌─────────────────────────┐
│ Inspection of physical   │
│       properties         │
└─────────────────────────┘
            │
            ▼
┌─────────────────────────┐
│      Evaluation          │
└─────────────────────────┘
```

EP 0 424 022 A2

## MANUFACTURING PROCESS FOR SUPERCONDUCTOR OF BI-PB-SR-CA-CU-O SERIES

### Field of the invention

The present invention relates to a manufacturing process for a superconductor of Bi-Pb-Sr-Ca-Cu-O series.

### Background of the invention

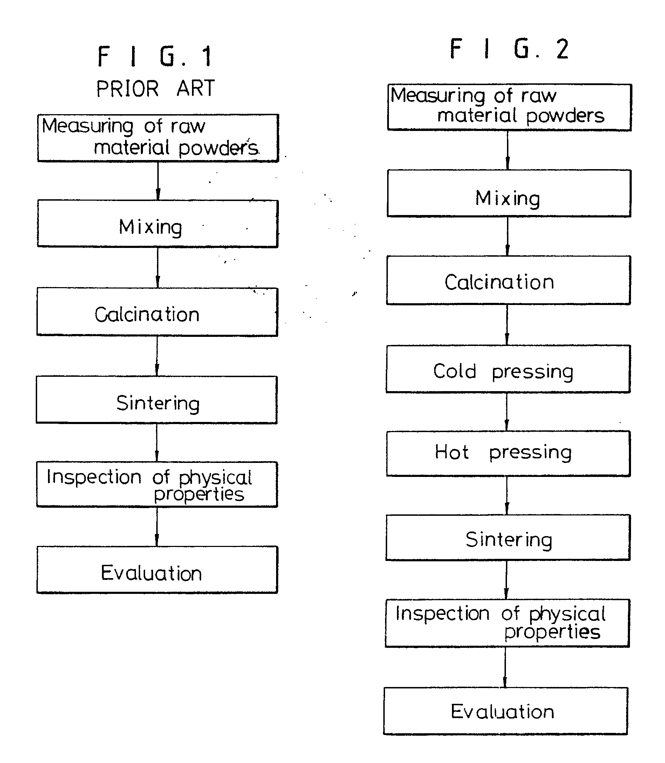

As shown in Figure 1, the conventional manufacturing process for the Bi series high temperature superconductor ceramics is consituted such that : the raw material powders of $Bi_2O_3$ , PbO, $SrCo_3$ , $CaCo_3$ and CuO are crushed and mixed for 12 - 48 hours by means of a ball mill ; calcinations are carried out at a temperature of 600 - 850° C two or three times repeatedly for 12 - 48 hours respectively ; and then, a sintering is carried out at a temperature of 800 - 900° C for 7 - 10 days.

The requirement that the sintering takes 7 - 10 days is an unecono mical feature of the conventional manufacturing process.

### Summary of the invention

The present invention is intended to overcome the above described disadvantages of the conventional manufacturing process.

Therefore it is the object of the present invention to provide a manufacturing process for a superconductor in which the manufacturing period is shortended, thereby contributing to improving the productivity.

### Brief description of the drawings

The above object and other advantages of the present invention will become more apparent by describing in detail the preferred embodiment of the present invention with reference to the attached drawings in which :

Figure 1 illustrates the manufacturing process for the conventional ceramics ;

Figure 2 illustrates the manufacturing process for the ceramics according to the present invention ;

Figure 4 is a graphical illustration of the variation of the specific resistivity as against the variations of the pressure and temperature ; and

Figure 5 is a graphical illustration of the variation of the inductance as against the variations of the temperature.

### Description of the preferred embodiment

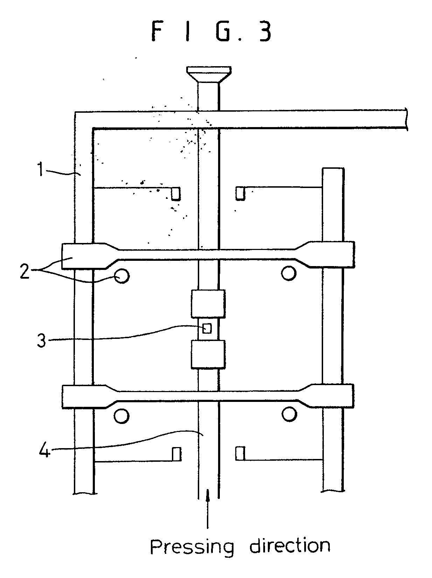

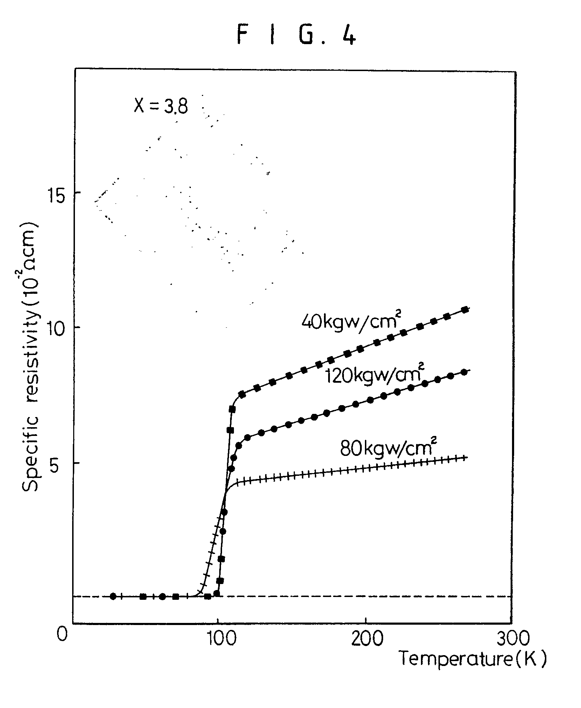

As shown in Figure 2, the manufacturing process for the high temperature superconductor ceramics according to the present invention is constituted such that : the powders of $Bi_2O_3$ , $SrCo_3$ , $CaCo_3$ , CuO and PbO as the raw material are measured in the mole ratios of 1.4 : 0.6 : 2 : 2 : 3.8 to add them together ; they are crushed and mixed together by means of a ball mill ; and then, the mixture is calcinated two or three times at a temperature of 600 - 800° C for 24 - 48 hours respectively. Thereafter, sintering is carried out at a temperature of 800 - 900° C for 48 hours, and then, a cold pressing is carried out to mold it in the desired size and shape. Then, using the pressing rod 4 of the hot press of Figure 3, pressure variations are imposed on the sample 3, and under this state, a sintering is carried out for two days.

According to the present invention as described above, a cold pressing and a hot pressing are carried out after performing a sintering, and then, the final sintering is carried out only for 2 days, whereas the conventional final sintering is 7 days, the difference ratio between the former and the latter being about one to three.

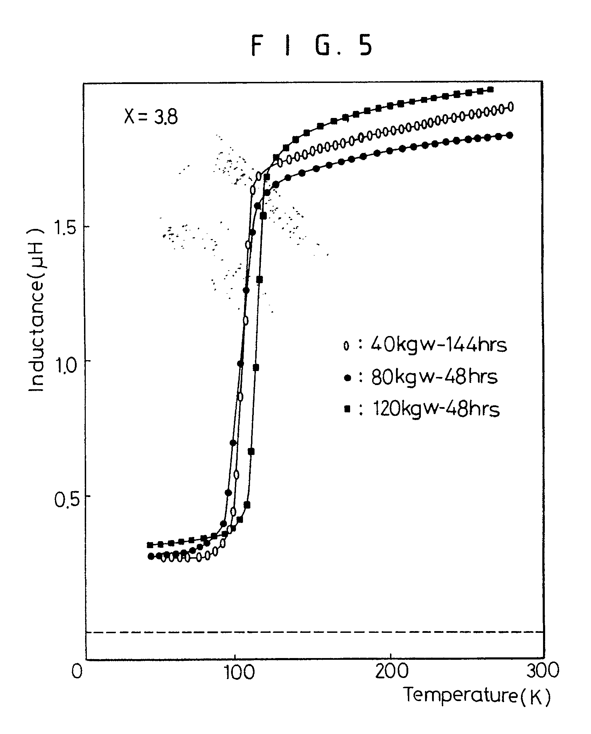

The superconductor ceramics of the present invention was tested as to its electric characteristics as shown in Figure 4, and as to its magnetic characteristics as shown in Figure 5, as against the variation of the pressure in both of the cases. During the testing of the electric characteristics, the critical temperature

2

TC(offset) of the superconductor was obtained as shown in Table 1 below.

Table 1

| Pressure (kg/cm$^3$) | TC(offset) |
|---|---|
| 40 | 109K |
| 80 | 92K |
| 120 | 112K |

## Claims

1. A manufacturing process for a high temperature superconductor of Bi-Pb-Sr-Ca-Cu-O series, comprising : step of measuring raw material powders of $Bi_2O_3$ , $SrCo_3$ , $CaCo_3$ , CuO and PbO ; step of crushing and mixing them by means of a ball mill ; step of calcinating the mixture two or three times at a temperature of 600 - 800° C for 24 - 48 hours ; step of carrying out a sintering out a cold pressing and a hot pressing at a temperature of 800 - 900° C ; and step of carrying out a sintering for two days.

# F I G. 1
## PRIOR ART

```
┌─────────────────────┐
│ Measuring of raw    │
│   material powders  │
└─────────────────────┘
          │
          ▼
┌─────────────────────┐
│      Mixing         │
└─────────────────────┘
          │
          ▼
┌─────────────────────┐
│    Calcination      │
└─────────────────────┘
          │
          ▼
┌─────────────────────┐
│     Sintering       │
└─────────────────────┘
          │
          ▼
┌─────────────────────┐
│ Inspection of physical │
│      properties     │
└─────────────────────┘
          │
          ▼
┌─────────────────────┐
│     Evaluation      │
└─────────────────────┘
```

# F I G. 2

```
┌─────────────────────┐
│ Measuring of raw    │
│   material powders  │
└─────────────────────┘
          │
          ▼
┌─────────────────────┐
│      Mixing         │
└─────────────────────┘
          │
          ▼
┌─────────────────────┐
│    Calcination      │
└─────────────────────┘
          │
          ▼
┌─────────────────────┐
│    Cold pressing    │
└─────────────────────┘
          │
          ▼
┌─────────────────────┐
│    Hot pressing     │
└─────────────────────┘
          │
          ▼
┌─────────────────────┐
│     Sintering       │
└─────────────────────┘
          │
          ▼
┌─────────────────────┐
│ Inspection of physical │
│      properties     │
└─────────────────────┘
          │
          ▼
┌─────────────────────┐
│     Evaluation      │
└─────────────────────┘
```

# F I G. 3

Pressing direction

F I G. 4

F I G. 5